(19) Europäisches Patentamt
European Patent Office
Office européen des brevets

(11) **EP 4 761 110 A1**

(12) **EUROPEAN PATENT APPLICATION**
published in accordance with Art. 153(4) EPC

(43) Date of publication:
**17.06.2026 Bulletin 2026/25**

(21) Application number: **23952241.0**

(22) Date of filing: **14.09.2023**

(51) International Patent Classification (IPC):
***H03H 19/00*** *(2006.01)*

(52) Cooperative Patent Classification (CPC):
**H03H 19/00**

(86) International application number:
**PCT/JP2023/033471**

(87) International publication number:
**WO 2025/057351 (20.03.2025 Gazette 2025/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Mitsubishi Electric Corporation
Tokyo 100-8310 (JP)**

(72) Inventors:
• **YAMASHITA, Shimpei
Tokyo 100-8310 (JP)**
• **HIRAI, Akihito
Tokyo 100-8310 (JP)**

(74) Representative: **Pfenning, Meinig & Partner mbB
Patent- und Rechtsanwälte
Theresienhöhe 11a
80339 München (DE)**

(54) **BANDPASS FILTER**

(57) According to a band-pass filter, n represents a natural number equal to or more than one, and the band-pass filter includes: an input terminal (1) to receive an input of an RF signal; a multi-phase splitter (3) to split the RF signal input to the input terminal into n RF signals whose phases each differ by 360 degrees/n; n signal paths (17 to 20) to receive from the multi-phase splitter, sample, and hold one of the n RF signals whose phases each differ by the 360 degrees/n, and output the held signal, the n signal paths being connected to the multi-phase splitter, and each signal path including a sample hold element including two switches; a multi-phase synthesizer (4) to synthesize n signals output from the n signal paths, the multi-phase synthesizer (4) being connected to the n signal paths; an output terminal (2) to output the signals to be synthesized by the multi-phase synthesizer; and a clock signal source (21) to output a clock signal (S1) for driving all of switches.

FIG. 1A

**(Cont. next page)**

EP 4 761 110 A1

# FIG. 1B

**Description**

TECHNICAL FIELD

The present disclosure relates to a band-pass filter.

BACKGROUND ART

Band-pass filters are used for wireless communication to eliminate interference waves or unnecessary waves. Patent Literature 1 discloses a technique related to a band-pass filter circuit. More specifically, Patent Literature 1 discloses a band-pass filter circuit that includes a switch that is connected between an input and an output, and switches an input signal voltage at a system clock frequency, a switched capacitor that is connected between the switch and a ground potential, a plurality of sample hold capacitors that are connected between the output and the ground potential, and a plurality of sample hold switches that are connected between the output and the ground potential, and are connected in series to the respective sample hold capacitors, and the sample hold switches are sequentially turned on one by one at a sampling clock frequency, hold a signal voltage appearing at a sample time in the sample hold capacitors, and cyclically and sequentially switches the sample hold switches.

CITATION LIST

PATENT LITERATURE

Patent Literature 1: JP 2011-82875 A

SUMMARY OF INVENTION

TECHNICAL PROBLEM

However, a configuration of cyclically and sequentially switching the sample hold switches as in Patent Literature 1 has a problem that it is difficult to generate a clock signal for switching the plurality of sample hold switches at a short signal period.
The present disclosure has been made to solve such a problem, and an object of the present disclosure is to provide a band-pass filter that allows an RF signal of a desired band to pass without cyclically and sequentially switching a plurality of switches.

SOLUTION TO PROBLEM

According to one aspect of a band-pass filter according to an embodiment of the present disclosure, n represents a natural number equal to or more than one, and the band-pass filter includes: an input terminal to receive an input of an RF signal; a multi-phase splitter to split the RF signal input to the input terminal into n RF signals whose phases each differ by 360 degrees/n; n signal paths to receive from the multi-phase splitter, sample, and hold one of the n RF signals whose phases each differ by the 360 degrees/n, and output the held signal, the n signal paths being connected to the multi-phase splitter, and each signal path including a sample hold element including two switches; a multi-phase synthesizer to synthesize n signals output from the n signal paths, the multi-phase synthesizer being connected to the n signal paths; an output terminal to output the signals to be synthesized by the multi-phase synthesizer; and a clock signal source to output a clock signal for driving all of switches.

ADVANTAGEOUS EFFECTS OF INVENTION

A band-pass filter according to the embodiments of the present disclosure can allow an RF signal of a desired band to pass without cyclically and sequentially switching a plurality of switches.

BRIEF DESCRIPTION OF DRAWINGS

FIG. 1A is a diagram illustrating a configuration of a band-pass filter according to Embodiment 1. FIG. 1B is a diagram illustrating an example of a waveform of a clock signal used by the band-pass filter in FIG. 1A.

FIG. 2 is a diagram illustrating the band-pass filter according to modified example 1 of Embodiment 1.

FIG. 3 is a diagram illustrating the band-pass filter according to modified example 2 of Embodiment 1.

FIG. 4A is a diagram illustrating a configuration of a band-pass filter according to Embodiment 2. FIG. 4B is a diagram illustrating an example of a waveform of a clock signal used by the band-pass filter in FIG. 4A.

FIG. 5A is a diagram illustrating a configuration of a band-pass filter in a case of n = 2 according to Embodiment 2. FIG. 5B is a diagram illustrating an example of a waveform of a clock signal used by the band-pass filter in FIG. 5A.

FIG. 6A is a diagram illustrating an example of a waveform of an RF signal to be input in a case of n = 2. FIG. 6B is a diagram illustrating an example of a waveform obtained by performing signal processing on the RF signals in signal paths in the case of n = 2. FIG. 6C is a diagram illustrating an example of a waveform of an RF signal output after synthesis processing in the case of n = 2.

FIG. 7A is a diagram illustrating a configuration of a band-pass filter according to Embodiment 3. FIG. 7B is a diagram illustrating an example of a waveform of a clock signal used by the band-pass filter in FIG. 7A.

FIG. 8A is a diagram illustrating a configuration of the band-pass filter in a case of n = 2 according to Embodiment 3. FIG. 8B is a diagram illustrating an example of a waveform of a clock signal used by the band-pass filter in FIG. 8A.

FIG. 9A is a diagram illustrating a configuration of a band-pass filter according to Embodiment 4. FIG. 9B is a diagram illustrating an example of a waveform of a clock signal used by the band-pass filter in FIG. 9A.

FIG. 10A is a diagram illustrating a configuration of the band-pass filter in a case of n = 2 according to Embodiment 4. FIG. 10B is a diagram illustrating an example of a waveform of a clock signal used by the band-pass filter in FIG. 10A.

FIG. 11 is a diagram illustrating a configuration example of a current control type amplification circuit included in the band-pass filter according to Embodiment 4.

FIG. 12 is a diagram illustrating frequency characteristics of pass characteristics of the current control type amplification circuit included in the band-pass filter according to Embodiment 4.

FIG. 13 is a diagram illustrating the frequency characteristics of the pass characteristics of the band-pass filter according to Embodiment 4.

DESCRIPTION OF EMBODIMENTS

Various embodiments of the present disclosure will be described in detail below with reference to the accompanying drawings. Note that components assigned the identical or similar reference numerals in the drawings will have identical or similar components or functions, and redundant description of these components will be omitted. Furthermore, a term "or" in the present disclosure is used to mean an inclusive or unless specified in particular.

Embodiment 1.

<Configuration>

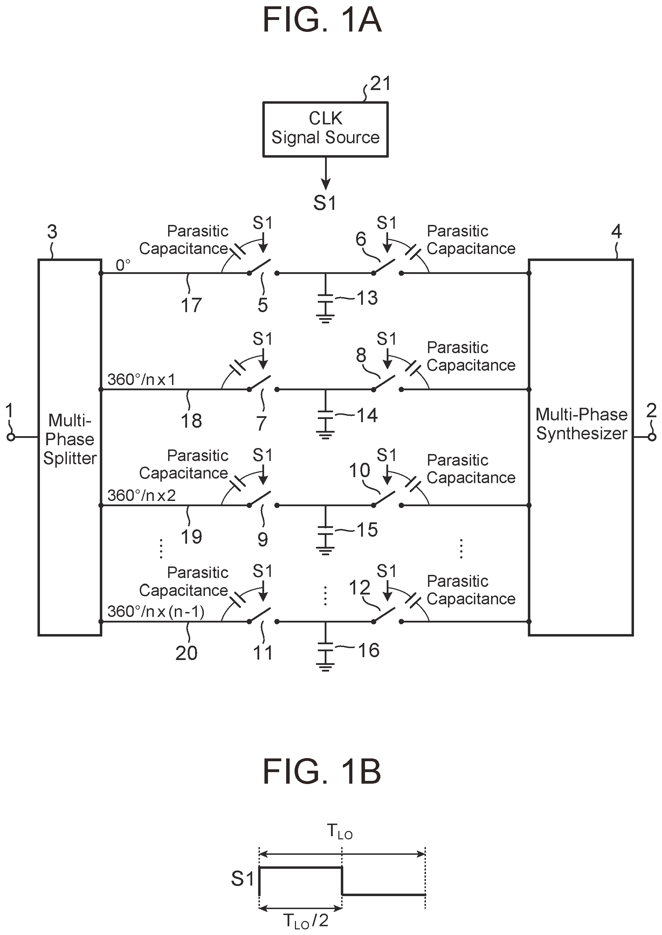

A band-pass filter according to Embodiment 1 of the present disclosure will be described with reference FIGS. 1 to 3. FIG. 1 is a circuit diagram illustrating the band-pass filter according to the first embodiment of the present disclosure. As illustrated in FIG. 1A, according to the band-pass filter according to Embodiment 1, n represents a natural number equal to or more than one, and the band-pass filter includes an input terminal 1 that receives an input of a Radio Frequency (RF) signal, a multi-phase splitter 3 that splits the RF signal input to the input terminal 1 into n RF signals whose phases each differ by 360 degrees/n, n signal paths 17 to 20 that are connected to the multi-phase splitter 3, each signal path of which includes a sample hold element including two switches, and that receives from the multi-phase splitter 3, samples, and holds one of the n RF signals whose phases each differ by the 360 degrees/n, and outputs the held signal, a multi-phase synthesizer 4 that is connected to the n signal paths 17 to 20 and synthesizes n signals output from the n signal paths 17 to 20, an output terminal 2 that outputs the signals to be synthesized by the multi-phase synthesizer 4, and a clock signal source 21 that outputs a clock signal S1 for driving all of switches.

(Clock Signal Source)

The clock signal source 21 outputs the clock signal S1 of a square wave whose duty ratio is 50% at a period $T_{LO}$ illustrated in, for example, FIG. 1B to drive all of the switches. Note that, as long as the band-pass filter operates as a desired filter, the duty ratio may not be 50%, and other waveforms such as a sine wave or a sawtooth wave having periodicity may be used.

(Switch)

Switches 5 to 12 are driven according to the clock signal S1 output from the clock signal source 21. The switches 5 to 12 are turned ON when the clock signal S1 is HIGH. The switches 5 to 12 have the same characteristics.

(Multi-Phase Splitter)

The multi-phase splitter 3 splits the RF signal input to the input terminal 1 into n signals whose phases each differ by 360 degrees/n. The multi-phase splitter 3 includes n output ports that output the split n signals.

(Signal Path)

Each signal path of the n signal paths includes sample hold elements. In one example, as illustrated in FIG. 1A, each signal path includes two switches and one capacitor as the sample hold elements. FIG. 1A more specifically illustrates the signal paths 17 to 20 of the n signal paths. Note that the example in FIG. 1A does not intend to limit n to an arbitrary integer equal to or more than four, and n may be a natural number equal to or more than one as described above. The signal path 17 includes the two switches 5 and 6 that are connected to the output port that outputs the RF signal of 0° among the outputs of the multi-phase splitter 3 and are connected in series, and a capacitor 13 that is connected between a connection point between the switches 5 and 6 and the ground. The signal path 18 includes the two switches 7 and 8 that are connected to the output port that outputs the RF signal of 360/n*1 degrees among the outputs of the multi-phase splitter 3 and are connected in series, and a capacitor 14 that is connected between a connection point between the switches 7 and 8 and the ground. The signal path 19 includes the two switches 9 and 10 that are connected to the output port that outputs the RF signal of 360/n*2 degrees among the outputs of the multi-phase splitter 3 and are connected in series, and a capacitor 15 that is connected between a connection point between the switches 9 and 10 and the ground. The signal path 20 includes the two switches 11 and 12 that are connected to the output port that outputs the RF signal of 360/n*(n-1) degrees among the outputs of the multi-phase splitter 3 and are connected in series, and a capacitor 16 that is connected between a connection point between the switches 11 and 12 and the ground. The capacitors 13 to 16 have the same characteristics.

(Multi-Phase Synthesizer)

The multi-phase synthesizer 4 synthesizes the n signals that are output from the signal paths 17, 18, 19, ..., and 20 and whose phases each differ by 360 degrees/n. The signal synthesized by the multi-phase synthesizer 4 is output to the output terminal 2.

<Operation>

The RF signal input to the input terminal 1 is split by the multi-phase splitter 3 into RF signals of a plurality of phases that each differ by 360 degrees/n. In a case of, for example, n = 3, the RF signal input from the input terminal 1 is split into RF signals of three phases that each differ by 120 degrees.
The split RF signal whose split phase is 0° is down-converted at a clock frequency when the clock signal S1 is HIGH (when the switch 5 is ON). Thereafter, the voltage is charged (low-pass filtered) to the capacitor 13, and the charged signal is up-converted when the clock signal S1 is HIGH (when the switch 6 is ON). These operations are also performed on the signal paths 18, 19, ..., and 20.
The signals output from the signal paths are added by the multi-phase synthesizer 4 to obtain an output signal.
The present embodiment differs from an operation procedure described in Patent Literature 1 in that input signals (RF signals) of multiple phases are down-converted or up-converted using the clock signal S1 of one phase. That is, unlike Patent Literature 1, according to the present embodiment, a plurality of switches are not cyclically and sequentially switched, in other words, an input signal of one phase is not down-converted or up-converted using clock signals of multiple phases. The band-pass filter according to the present embodiment can obtain band-pass filter characteristics of a narrow band whose center frequency is the clock signal frequency. Note that the phase of the clock signal at the time of down-conversion and at the time of up-conversion do not need to match. In this regard, the phases of the clock signals for down-conversion need to match in all paths, and the phases of the clock signals for up-conversion need to match in all paths. In a case where the phases of the clock signals for down-conversion do not match in all paths, intervals to be down-converted are shifted, a voltage value to be charged to the capacitor changes, and pass characteristics deteriorate. Furthermore, in a case where the phases of the clock signals for up-conversion do not match in all paths, a sample interval and a hold interval are shifted from each other and pass characteristics deteriorate.

<Modified Example 1>

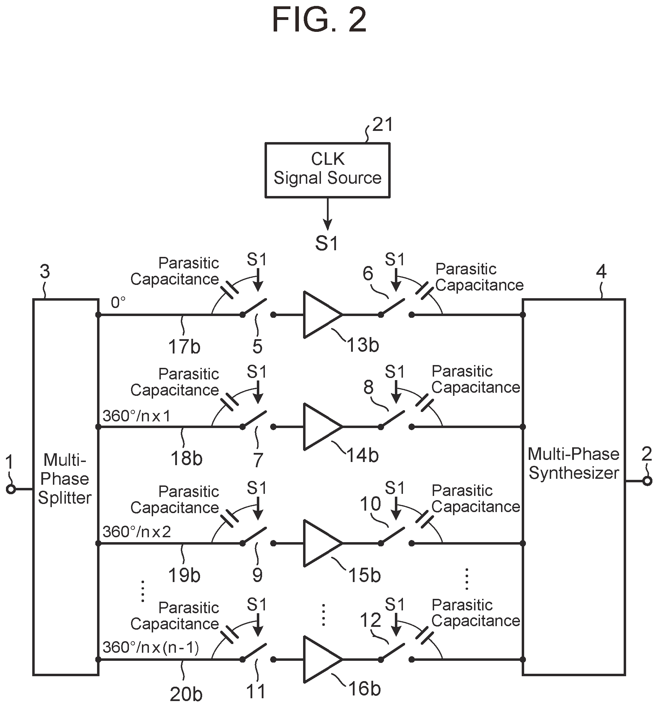

Although FIG. 1A illustrates the example where the sample hold element is configured using the capacitor, the sample hold element may be configured using another electronic part or a circuit. As illustrated in, for example, FIG. 2, the sample hold element may be configured using first-order time-lag system active circuits (13b to 16b) instead of the capacitor. The first-order time-lag system active circuits 13b to 16b are, for example, varactor diodes or amplifiers. Note that the active circuit used for each signal path has the same characteristics. FIG. 2 more specifically illustrates the signal paths 17b to 20b of the n signal paths. The signal path 17b includes the two switches 5 and 6 that are connected to the output port that outputs a signal of 0° among the outputs of the multi-phase splitter 3 and are connected in series, and the first-order time-lag system active circuit 13b that is connected between the switches 5 and 6. The signal path 18b includes the two switches 7 and 8 that are connected to the output port that outputs a signal of 360/n*1 degrees among the outputs of the multi-phase splitter 3 and are connected in series, and the first-order time-lag system active circuit 14b that is connected between the switches 7 and 8. The signal path 19b includes the two switches 9 and 10 that are connected to the output port that outputs a signal of 360/n*2 degrees among the outputs of the multi-phase splitter 3 and are connected in series, and the first-order time-lag system active circuit 15b that is connected between the switches 9 and 10. The signal path 20b includes the two switches 11 and 12 that are connected to the output port that outputs a signal of 360/n*(n-1) degrees among the outputs of the multi-phase splitter 3 and are connected in series, and the first-order time-lag system active circuit 16b that is connected between the switches 11 and 12.

<Modified Example 2>

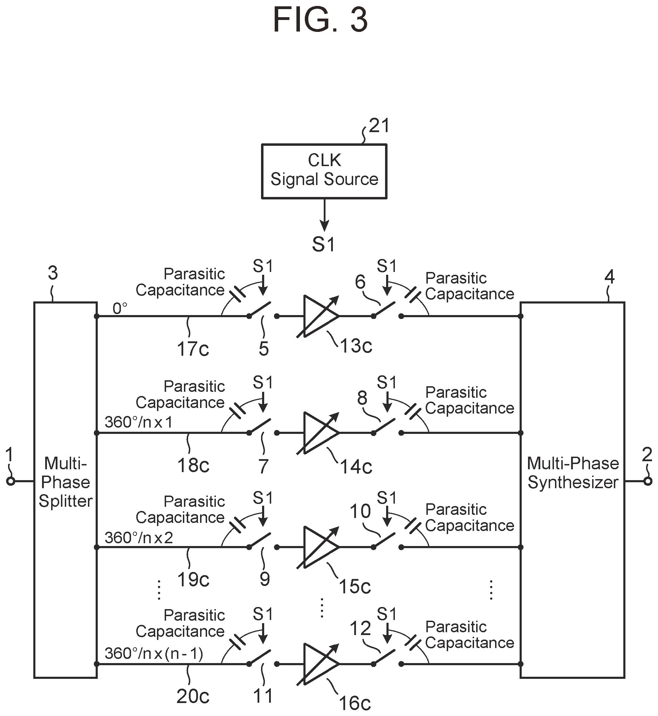

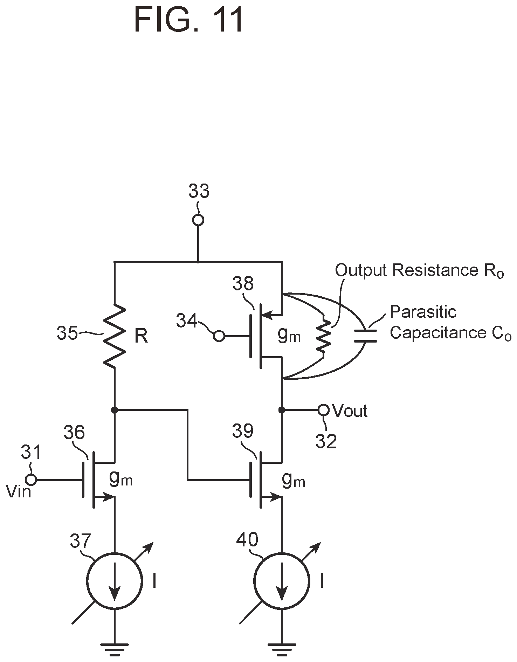

In still another example, as illustrated in FIG. 3, the sample hold element may be configured using current control type amplification circuits (13c to 16c) instead of the capacitor. FIG. 3 more specifically illustrates the signal paths 17c to 20c of the n signal paths. As illustrated in FIG. 3, the signal path 17c includes the two switches 5 and 6 that are connected to the output port that outputs a signal of 0° among the outputs of the multi-phase splitter 3 and are connected in series, and the current control type amplification circuit 13c that is connected between the switches 5 and 6. The signal path 18c includes the two switches 7 and 8 that are connected to the output port that outputs a signal of 360/n*1 degrees among the outputs of the multi-phase splitter 3 and are connected in series, and the current control type amplification circuit 14c that is connected between the switches 7 and 8. The signal path 19c includes the two switches 9 and 10 that are connected to the output port that outputs a signal of 360/n*2 degrees among the outputs of the multi-phase splitter 3 and are connected in series, and the current control type amplification circuit 15c that is connected between the switches 9 and 10. The signal path 20c includes the two switches 11 and 12 that are connected to the output port that outputs a signal of 360/n*(n-1) degrees among the outputs of the multi-phase splitter 3 and are connected in series, and the current control type amplification circuit 16c that is connected between the switches 11 and 12. The current control type amplification circuit used for each signal path has the same characteristics. A circuit as illustrated in FIG. 11 may be used as each current control type amplification circuit. A configuration example illustrated in FIG. 11 will be described later in Embodiment 4.

Embodiment 2.

<Configuration>

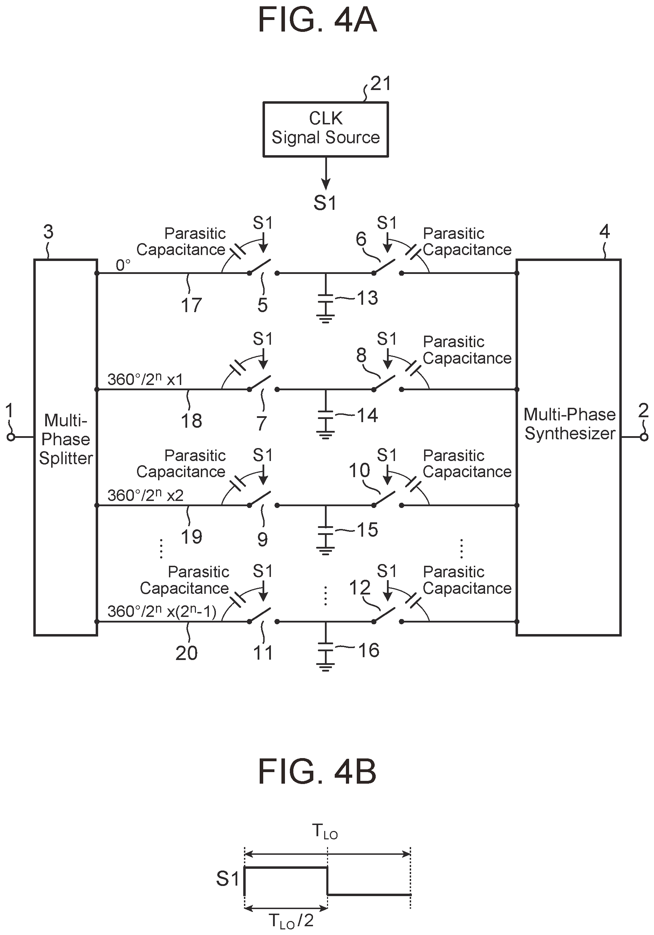

A band-pass filter according to Embodiment 2 of the present disclosure will be described with reference FIGS. 4 to 6. FIG. 4 is a circuit diagram illustrating the band-pass filter according to the second embodiment of the present disclosure. As illustrated in FIG. 4A, according to the band-pass filter according to Embodiment 2, n represents a natural number equal to or more than one, and the band-pass filter includes the input terminal 1 that receives an input of an Radio Frequency (RF) signal, the multi-phase splitter 3 that splits the RF signal input to the input terminal 1 into $2^n$ RF signals whose phases each differ by 360 degrees/$2^n$, the $2^n$ signal paths 17 to 20 that are connected to the multi-phase splitter 3, each signal path of which includes a sample hold element including two switches, and that receives, from the multi-phase splitter 3, one of the $2^n$ RF signals whose phases each differ by the 360 degrees/$2^n$, samples and holds the received signal, and outputs the held signal, the multi-phase synthesizer 4 that is connected to the $2^n$ signal paths 17 to 20 and synthesizes $2^n$ signals output from the $2^n$ signal paths 17 to 20, the output terminal 2 that outputs the signals to be synthesized by the multi-phase synthesizer 4, and the clock signal source 21 that outputs the clock signal S1 for driving all of switches through signal paths having the equal lengths.

(Clock Signal Source)

The clock signal source 21 outputs the clock signal S1 of a square wave whose duty ratio is 50% at the period $T_{LO}$ illustrated in, for example, FIG. 4B to drive all of the switches. Note that, as long as the band-pass filter operates as a desired filter, the duty ratio may not be 50%, and other waveforms such as a sine wave or a sawtooth wave having periodicity may be used. The signal paths from the clock signal source 21 to the switches 5 to 12 have the equal lengths.

(Switch)

The switches 5 to 12 are driven by the clock signal S1 output from the clock signal source 21. The switches 5 to 12 are turned ON when the clock signal S1 is HIGH. The switches 5 to 12 have the same characteristics.

(Multi-Phase Splitter)

The multi-phase splitter 3 splits the RF signal input to the input terminal 1 into $2^n$ signals whose phases each differ by 360 degrees/$2^n$. By adjusting the lengths of line paths in the multi-phase splitter 3, it is possible to give a phase difference. The multi-phase splitter 3 includes $2^n$ output ports that output the split $2^n$ signals.

(Signal Path)

Each signal path of the $2^n$ signal paths includes sample hold elements. In one example, as illustrated in FIG. 4A, each signal path includes two switches and one capacitor as the sample hold elements. FIG. 4A more specifically illustrates the signal paths 17 to 20 of the $2^n$ signal paths. The signal path 17 includes the two switches 5 and 6 that are connected to the output port that outputs the RF signal of 0° among the outputs of the multi-phase splitter 3 and are connected in series, and the capacitor 13 that is connected between the connection point between the switches 5 and 6 and the ground. The signal path 18 includes the two switches 7 and 8 that are connected to the output port that outputs the RF signal of $360/2^n*1$ degrees among the outputs of the multi-phase splitter 3 and are connected in series, and the capacitor 14 that is connected between the connection point between the switches 7 and 8 and the ground. The signal path 19 includes the two switches 9 and 10 that are connected to the output port that outputs the RF signal of $360/2^n*2$ degrees among the outputs of the multi-phase splitter 3 and are connected in series, and the capacitor 15 that is connected between the connection point between the switches 9 and 10 and the ground. The signal path 20 includes the two switches 11 and 12 that are connected to the output port that outputs the RF signal of $360/2^n*(2^n-1)$ degrees among the outputs of the multi-phase splitter 3 and are connected in series, and the capacitor 16 that is connected between the connection point between the switches 11 and 12 and the ground. The capacitors 13 to 16 have the same characteristics.

(Multi-Phase Synthesizer)

The multi-phase synthesizer 4 synthesizes the $2^n$ signals that are output from the signal paths 17, 18, 19, ..., and 20 and whose phases each differ by 360 degrees/$2^n$. The signal synthesized by the multi-phase synthesizer 4 is output to the output terminal 2.

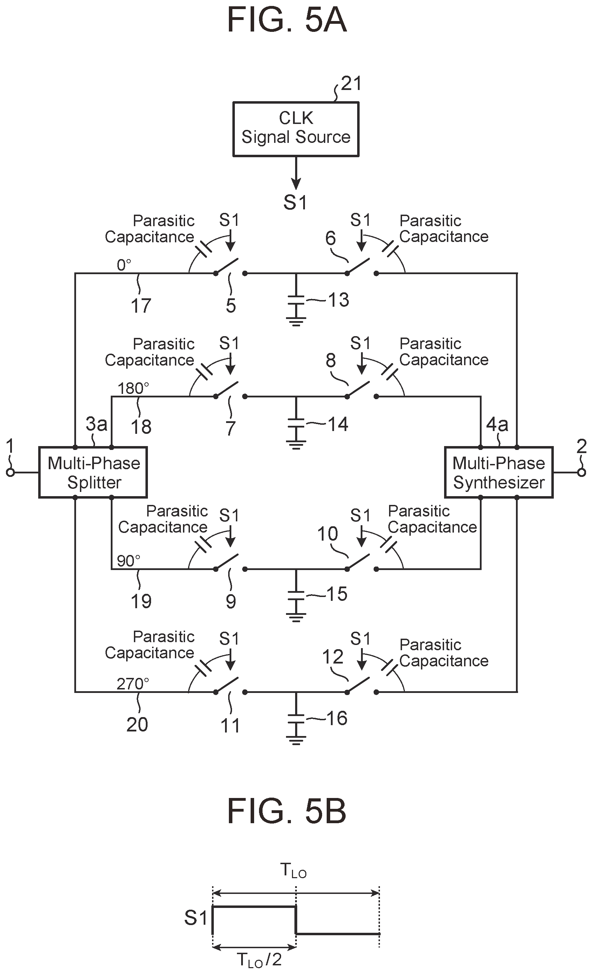

FIG. 5A illustrates a circuit diagram in a case of n = 2 as an example according to Embodiment 2. Since n = 2 holds, the number of signal paths is 4(= $2^2$). A specific connection relationship other than the number of signal paths is the same as that in the case in FIG. 4A. Furthermore, FIG. 5B is a diagram illustrating an example of a waveform of a clock signal used by the band-pass filter in FIG. 5A.

<Operation>

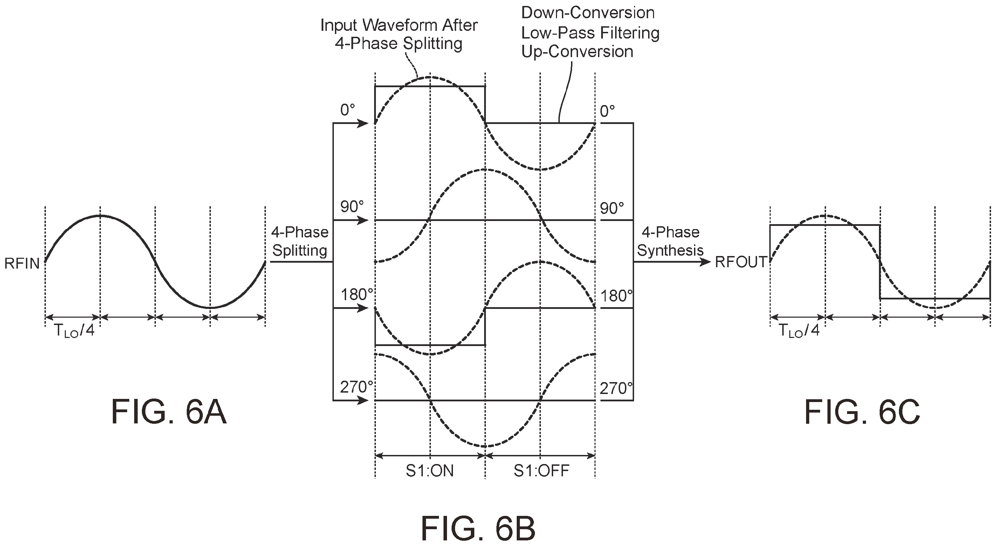

FIG. 6 is a diagram illustrating an example of a waveform at each stage in the case of n = 2 according to Embodiment 2.

FIG. 6A is a diagram illustrating an example of a waveform of an RF signal to be input. FIG. 6B is a diagram illustrating an example of waveforms obtained by performing signal processing on the RF signals in signal paths. FIG. 6C is a diagram illustrating an example of a waveform of an RF signal output after synthesis processing.

In the case of n = 2, after the input signal is split into four phases by a multi-phase splitter 3a, the RF signal whose split phase is 0° is down-converted at a clock frequency when the clock signal S1 is HIGH (when the switch 5 is ON). Thereafter, the voltage is charged (low-pass filtered) to the capacitor 13, and the charged signal is up-converted when the clock signal S1 is HIGH (when the switch 6 is ON).

These operations are also performed on the signal paths 18, 19, ..., and 20. FIG. 6B illustrates waveforms of signals of signal paths after down-conversion, low-pass filtering, and up-conversion. The signals output from the signal paths are added by the multi-phase synthesizer 4a to obtain an output signal illustrated in FIG. 6C.

The present embodiment differs from an operation procedure described in Patent Literature 1 in that input signals (RF signals) of four phases are down-converted or up-converted using the clock signal S1 of one phase. The band-pass filter according to the present embodiment can obtain band-pass filter characteristics of a narrow band whose center frequency is the clock signal frequency. Note that the phase of the clock signal at the time of down-conversion and at the time of up-conversion may not need to match. In this regard, the phases of the clock signals for down-conversion need to match in all paths, and the phases of the clock signals for up-conversion need to match in all paths. In a case where the phases of the clock signals for down-conversion do not match in all paths, intervals to be down-converted are shifted, a voltage value to be charged to the capacitor changes, and pass characteristics deteriorate. Furthermore, in a case where the phases of the clock signals for up-conversion do not match in all paths, a sample interval and a hold interval are shifted from each other and pass characteristics deteriorate.

In the present embodiment, since the signal paths from the clock signal source to the switches match, virtual short-circuiting occurs at a clock signal path end via a parasitic capacitance of each down-conversion switch between signal paths having a phase difference of 180°. Consequently, loss of the clock signal source becomes invisible, and it is possible to provide the band-pass filter that improves high frequency pass characteristics of an input signal.

Embodiment 3.

<Configuration>

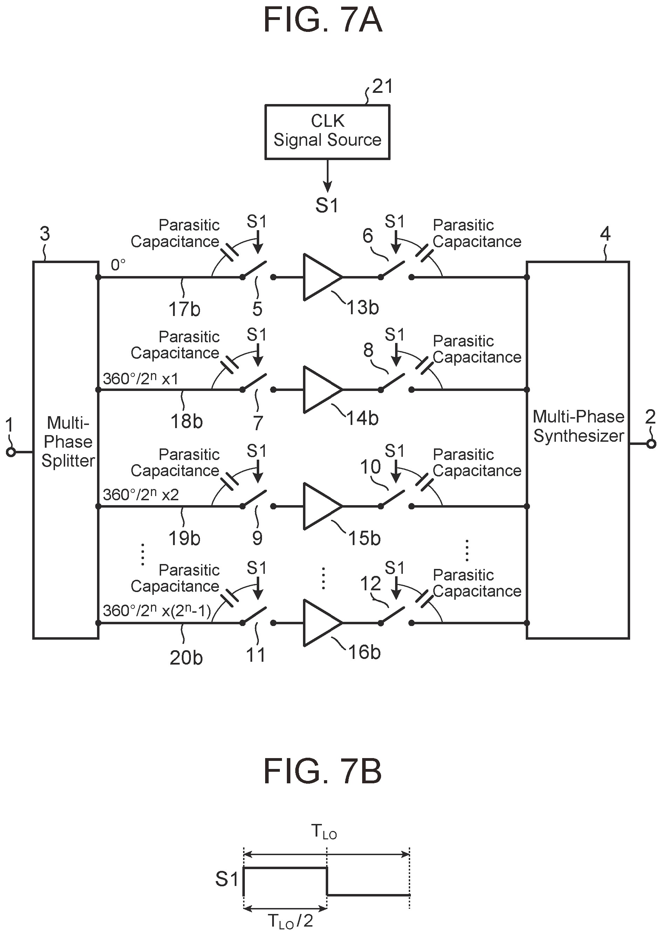

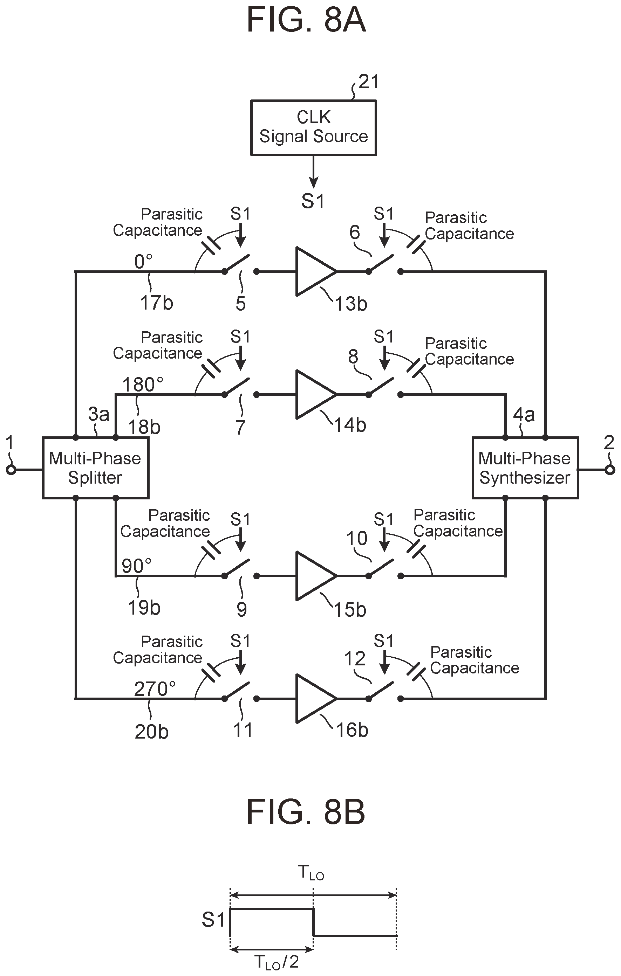

Next, a band-pass filter according to Embodiment 3 of the present disclosure will be described with reference FIGS. 7 and 8. FIG. 7A is a circuit diagram illustrating the band-pass filter according to the third embodiment of the present disclosure. As illustrated in FIG. 7A, the band-pass filter according to Embodiment 3 includes the input terminal 1, the output terminal 2, the multi-phase splitter 3, the multi-phase synthesizer 4, and the $2^n$ signal paths 17b to 20b. The signal paths 17b to 20b include the switches 5 to 12 and the first-order time-lag system active circuits 13b to 16b.

(Clock Signal Source)

The clock signal source 21 outputs the clock signal S1 of a square wave whose duty ratio is 50% at the period $T_{LO}$ illustrated in, for example, FIG. 7B. Note that, as long as the band-pass filter operates as a desired filter, the duty ratio may not be 50%, and other waveforms such as a sine wave or a sawtooth wave having periodicity may be used. The signal paths from the clock signal source 21 to the switches 5 to 12 have the equal lengths.

(Switch)

The switches 5 to 12 are controlled according to the clock signal S1 output from the clock signal source 21. The switches 5 to 12 are turned ON when the clock signal S1 is HIGH. The switches 5 to 12 have the same characteristics.
The first-order time-lag system active circuits 13b to 16b are, for example, varactor diodes or amplifiers. Note that the active circuit used for each signal path has the same characteristics.

(Multi-Phase Splitter)

The multi-phase splitter 3 splits the RF signal input to the input terminal 1 into $2^n$ signals whose phases each differ by 360 degrees/$2^n$. By adjusting the lengths of line paths in the multi-phase splitter 3, it is possible to give a phase difference. The multi-phase splitter 3 includes $2^n$ output ports that output the split $2^n$ signals.

(Signal Path)

Each signal path of the $2^n$ signal paths includes sample hold elements. In one example, as illustrated in FIG. 7A, each signal path includes two switches and one first-order time-lag system active circuit. FIG. 7A more specifically illustrates the signal paths 17b to 20b of the $2^n$ signal paths. The signal path 17b includes the two switches 5 and 6 that are connected to the output port that outputs a signal of 0° among the outputs of the multi-phase splitter 3 and are connected in series, and the first-order time-lag system active circuit 13b that is connected between the switches 5 and 6. The signal path 18b includes the two switches 7 and 8 that are connected to the output port that outputs a signal of $360/2^n*1$ degrees among the outputs of the multi-phase splitter 3 and are connected in series, and the first-order time-lag system active circuit 14b that is connected between the switches 7 and 8. The signal path 19b includes the two switches 9 and 10 that are connected to the output port that outputs a signal of $360/2^n*2$ degrees among the outputs of the multi-phase splitter 3 and are connected in series, and the first-order time-lag system active circuit 15b that is connected between the switches 9 and 10. The signal path 20b includes the two switches 11 and 12 that are connected to the output port that outputs a signal of $360/2^n*(2^n-1)$ degrees among the outputs of the multi-phase splitter 3 and are connected in series, and the first-order time-lag system active circuit 16b that is connected between the switches 11 and 12.

(Multi-Phase Synthesizer)

The multi-phase synthesizer 4 synthesizes the $2^n$ signals that are output from the signal paths 17b, 18b, 19b, ...,

and 20b and whose phases each differ by 360 degrees/$2^n$. The signal synthesized by the multi-phase synthesizer 4 is output to the output terminal 2.

FIG. 8A illustrates a circuit diagram in a case of n = 2 as an example according to Embodiment 3. Since n = 2 holds, the number of signal paths is 4($= 2^2$). A specific connection relationship other than the number of signal paths is the same as that in the case in FIG. 7A. Furthermore, FIG. 8B is a diagram illustrating an example of a waveform of a clock signal used by the band-pass filter in FIG. 8A.

<Operation>

Sketches of an input waveform, a waveform subjected to signal processing in each signal path, and an output waveform are the same as those in the case in FIG. 6. Since the first-order time-lag system active circuits function similarly to the capacitor, the band-pass filter according to Embodiment 3 operates similarly to the case in Embodiment 2. Note that a pass bandwidth is determined on the basis of a value corresponding to a capacitance of the first-order time-lag system active circuit.

In the case of n = 2, after the input signal is split into four phases by the multi-phase splitter 3a, the RF signal whose split phase is 0° is down-converted at a clock frequency when the clock signal S1 is HIGH (when the switch 5 is ON). Thereafter, the voltage is charged (low-pass filtered) to the first-order time-lag system active circuit 13b, and the charged signal is up-converted when the clock signal S1 is HIGH (when the switch 6 is ON).

These operations are also performed on the signal paths 18b, 19b, ..., and 20b. The waveforms of the signal paths after up-conversion are as illustrated in FIG. 6B, and the signals output from the signal paths are added by the multi-phase synthesizer 4a to obtain an output signal illustrated in FIG. 6C.

Although an input signal of one phase is down-converted or up-converted using clock signals of four phases in Patent Literature 1, the present embodiment differs from the technique of Patent Literature 1 in that input signals of four phases are down-converted or up-converted using a clock signal of one phase in the present embodiment. The band-pass filter according to the present embodiment can obtain band-pass filter characteristics of a narrow band whose center frequency is the clock signal frequency similarly to the filter of Patent Literature 1. Note that the phase of the clock signal at the time of down-conversion and at the time of up-conversion do not need to match. In this regard, the phases of the clock signals for down-conversion need to match in all paths, and the phases of the clock signals for up-conversion need to match in all paths. In a case where the phases of the clock signals for down-conversion do not match in all paths, intervals to be down-converted are shifted, a voltage value to be charged to the first-order time-lag system active circuit changes, and pass characteristics deteriorate. Furthermore, in a case where the phases of the clock signals for up-conversion do not match in all paths, a sample interval and a hold interval are shifted from each other and pass characteristics deteriorate.

In the present embodiment, since the signal paths from the clock signal source to the switches match, virtual short-circuiting occurs at a clock signal path end via a parasitic capacitance of each down-conversion switch between signal paths having a phase difference of 180°. Consequently, loss of the clock signal source becomes invisible, and it is possible to provide the band-pass filter that improves high frequency pass characteristics of an input signal. In addition, in a case where varactor diodes are used as the first-order time-lag system active circuits, it is possible to perform voltage control on capacitance values and consequently achieve variability of the pass bandwidth. In a case where the varactor diodes are replaced with amplifiers, it is possible to improve pass characteristics.

Embodiment 4.

<Configuration>

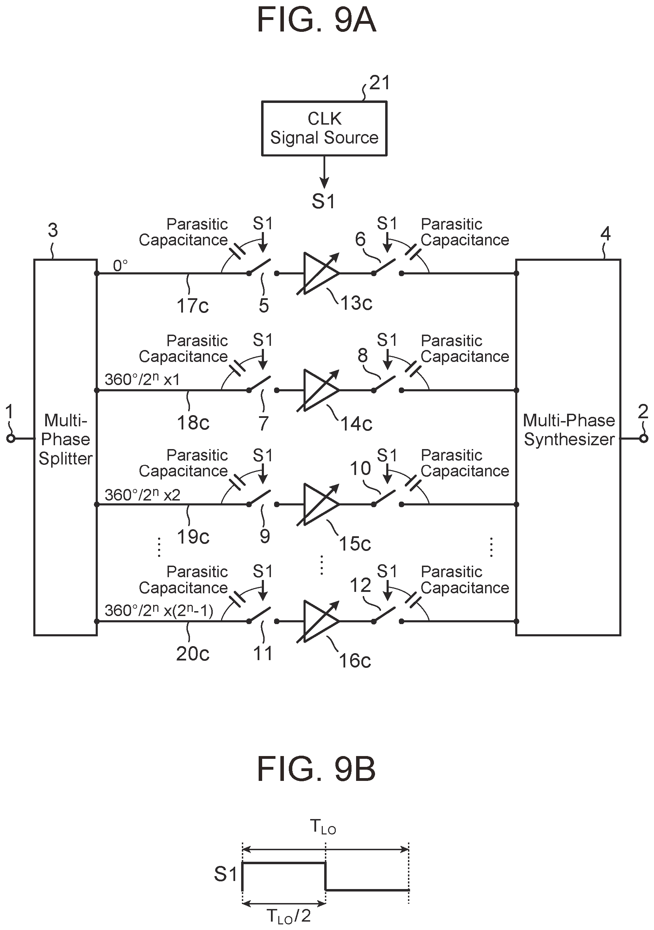

Next, a band-pass filter according to Embodiment 4 of the present disclosure will be described with reference FIGS. 9 to 13. FIG. 9A is a circuit diagram illustrating the band-pass filter according to the fourth embodiment of the present disclosure. The circuit diagram in FIG. 9A differs from the circuit diagram in FIG. 7A in that the first-order time-lag system active circuits in FIG. 7A are replaced with current control type amplification circuits. As illustrated in FIG. 9A, the band-pass filter according to Embodiment 4 includes the input terminal 1, the output terminal 2, the multi-phase splitter 3, the multi-phase synthesizer 4, and the $2^n$ signal paths 17C to 20c. The signal paths 17c to 20c include the switches 5 to 12 and the current control type amplification circuits 13c to 16c. The current control type amplification circuits 13c to 16c are amplification circuits that are a first-order time-lag system and have constant pass gains even when a pass bandwidth is made variable by current control.

(Clock Signal Source)

The clock signal source 21 outputs the clock signal S1 of a square wave whose duty ratio is 50% at the period $T_{LO}$ illustrated in, for example, FIG. 9B. Note that, as long as the band-pass filter operates as a desired filter, the duty ratio may not be 50%, and other waveforms such as a sine wave or a sawtooth wave having periodicity may be used. The signal paths from the clock signal source 21 to the switches 5 to 12 have the equal lengths.

(Switch)

The switches 5 to 12 are controlled according to the clock signal S1 output from the clock signal source 21. The switches 5 to 12 are turned ON when the clock signal S1 is HIGH. The switches 5 to 12 have the same characteristics.

(Multi-Phase Splitter)

The multi-phase splitter 3 splits a signal input to the input terminal 1 into $2^n$ signals whose phases each differ by 360 degrees/$2^n$. By adjusting the lengths of line paths in the multi-phase splitter 3, it is possible to give a phase difference. The multi-phase splitter 3 includes $2^n$ output ports that output the split $2^n$ signals.

(Signal Path)

Each signal path of the $2^n$ signal paths includes sample hold elements. In one example, as illustrated in FIGS. 9A and 11, each signal path includes two switches and one current control type amplification circuit. FIG. 9A more specifically illustrates the signal paths 17c to 20c of the $2^n$ signal paths. FIG. 11 illustrates an example of a current control type amplification circuit. As illustrated in FIG. 9A, the signal path 17c includes the two switches 5 and 6 that are connected to the output port that outputs a signal of 0° among the outputs of the multi-phase splitter 3 and are connected in series, and the current control type amplification circuit 13c that is connected between the switches 5 and 6. The signal path 18c includes the two switches 7 and 8 that are connected to the output port that outputs a signal of 360/$2^n$*1 degrees among the outputs of the multi-phase splitter 3 and are connected in series, and the current control type amplification circuit 14c that is connected between the switches 7 and 8. The signal path 19c includes the two switches 9 and 10 that are connected to the output port that outputs a signal of 360/$2^n$*2 degrees among the outputs of the multi-phase splitter 3 and are connected in series, and the current control type amplification circuit 15c that is connected between the switches 9 and 10. The signal path 20c includes the two switches 11 and 12 that are connected to the output port that outputs a signal of 360/$2^n$*($2^n$-1) degrees among the outputs of the multi-phase splitter 3 and are connected in series, and the current control type amplification circuit 16c that is connected between the switches 11 and 12. The current control type amplification circuit used for each signal path has the same characteristics.

(Multi-Phase Synthesizer)

The multi-phase synthesizer 4 synthesizes the $2^n$ signals that are output from the signal paths 17c, 18c, 19c, ..., and 20c and whose phases each differ by 360 degrees/$2^n$. The signal synthesized by the multi-phase synthesizer 4 is output to the output terminal 2.

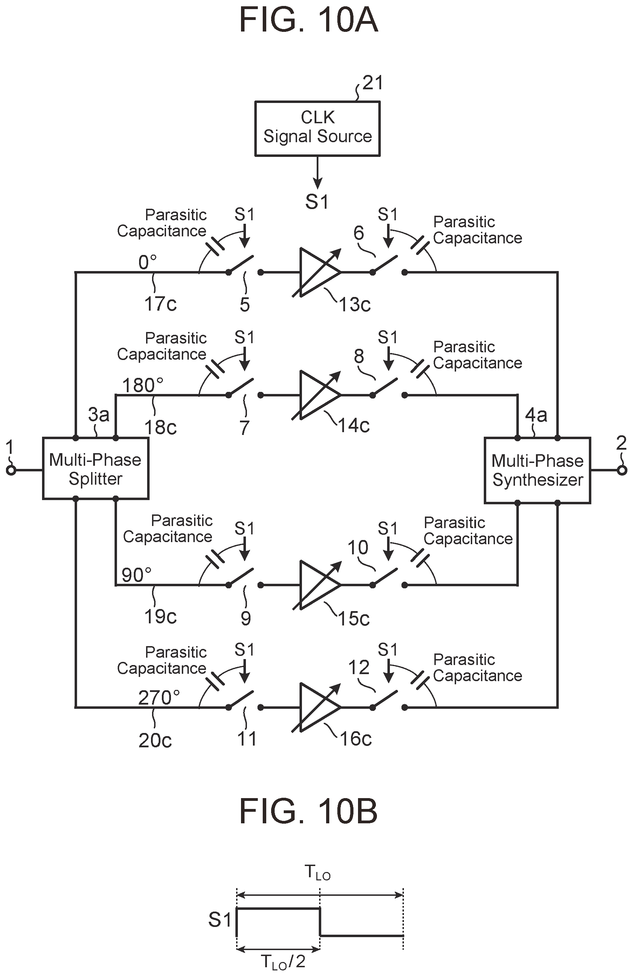

FIG. 10A illustrates a circuit diagram in a case of n = 2 as an example according to Embodiment 4. Since n = 2 holds, the number of signal paths is 4(= $2^2$). A specific connection relationship other than the number of signal paths is the same as that in the case in FIG. 9A. Furthermore, FIG. 10B is a diagram illustrating an example of a waveform of a clock signal used by the band-pass filter in FIG. 10A.

FIG. 11 illustrates an example of a current control type amplification circuit according to Embodiment 4. An input voltage Vin input to an input terminal 31 (second input terminal) is connected to a gate terminal of an N-type transistor 36 (first N-type transistor). A resistance 35 is connected between a power supply terminal 33 and a drain terminal of the N-type transistor 36. A variable current source 37 (first current source) is connected between a source terminal of the N-type transistor 36 and the ground. A gate terminal of an N-type transistor 39 (second N-type transistor) is connected to the drain terminal of the N-type transistor 36. A current source 40 (second current source) is connected between a source terminal of the N-type transistor 39 and the ground. A source terminal of a P-type transistor 38 is connected to the power supply terminal 33, a gate terminal of the P-type transistor 38 is connected to a bias terminal 34, and a drain terminal of the P-type transistor 38 is connected to a drain terminal of the N-type transistor 39. An output terminal 32 (second output terminal) is connected with the drain terminal of the N-type transistor 39 and the drain terminal of the P-type transistor 38.

An output voltage Vout of an amplification circuit in FIG. 11 is expressed by the following equation (1) from a resistance value R of the resistance 35, transconductances gm of the N-type transistors 36 and 39, an output resistance Ro of the P-type transistor 38, currents I to be supplied by variable current sources 37 and 40, and an input voltage Vin. In the equation (1), $\beta$ represents gain coefficients of the N-type transistors 36 and 39, and $\lambda$ represents a channel modulation effect coefficient of the P-type transistor 38.

$$V_{out} = g_m{}^2 R_o R V_{in} = 2\beta I \cdot \frac{1}{\lambda l} \cdot R V_{in} = \frac{2\beta R \cdot}{\lambda} V_{in} \qquad (1)$$

A treble cutoff frequency fc is expressed by the following equation (2). Co represents a parasitic capacitance between the drain and the source of the P-type transistor 38.

$$f_c = \frac{\lambda l}{2\pi C_o} \qquad (2)$$

A passband variable range is expressed by the following equation (3). In the equation (3), Imin and Imax represent a minimum current and a maximum current of the variable current sources, respectively.

$$\frac{\lambda I_{min}}{2\pi C_o} \leq f_c \leq \frac{\lambda I_{max}}{2\pi C_o} \qquad (3)$$

As described above, a voltage gain is determined on the basis of the sizes and the resistance values R of the N-type transistors 36 and 39 and the P-type transistor 38 without depending on current control of the variable current sources 37 and 40. Furthermore, the treble cutoff frequency fc can be made variable by performing current control on the variable current sources 37 and 40. In a case where, for example, the currents I of the variable current sources 37 and 40 have dynamic ranges of 1000 times from approximately 1 uA to 1 mA, it is possible to make a band variable in a wide band including the dynamic range whose variation quantity of the passband is approximately 1000 times.

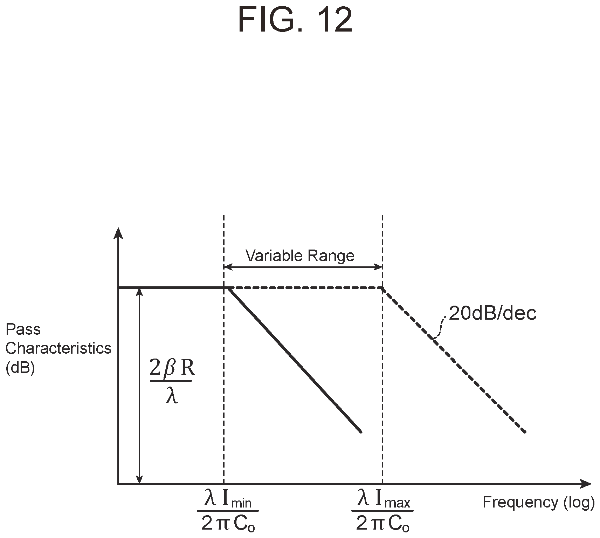

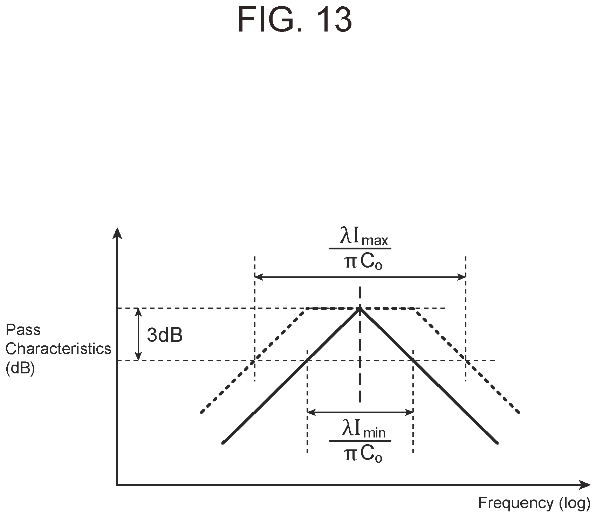

FIGS. 12 and 13 illustrate a voltage gain of the amplification circuit and pass characteristics of the band-pass filter. A 3 dB band of the band-pass filter is twice as large as the treble cutoff frequency fc of the amplification circuit.

<Operation>

Sketches of an input waveform, a waveform subjected to signal processing in each signal path, and an output waveform are the same as those in the case in FIG. 6.

In the case of n = 2, after the input signal is split into four phases by the multi-phase splitter 3a, the RF signal whose split phase is 0° is down-converted at a clock frequency when the clock signal S1 is HIGH (when the switch 5 is ON). Thereafter, the voltage is charged (low-pass filtered) to the current control type amplification circuit 13c, and the charged signal is up-converted when the clock signal S1 is HIGH (when the switch 6 is ON).

These operations are also performed on the signal paths 18c, 19c, ..., and 20c. The waveforms of the signal paths after up-conversion are as illustrated in FIG. 6B, and the signals output from the signal paths are added by the multi-phase synthesizer 4a to obtain an output signal illustrated in FIG. 6C.

Although an input signal of one phase is down-converted or up-converted using clock signals of four phases in Patent Literature 1, the present embodiment differs from the technique of Patent Literature 1 in that input signals of four phases are down-converted or up-converted using a clock signal of one phase in the present embodiment. The band-pass filter according to the present embodiment can obtain band-pass filter characteristics of a narrow band whose center is the clock signal frequency similarly to the filter of Patent Literature 1. Note that the phase of the clock signal at the time of down-conversion and at the time of up-conversion do not need to match. In this regard, the phases of the clock signals for down-conversion need to match in all paths, and the phases of the clock signals for up-conversion need to match in all paths. In a case where the phases of the clock signals for down-conversion do not match, intervals to be down-converted are shifted, a voltage value to be charged to the current control type amplification circuit changes, and pass characteristics deteriorate. Furthermore, in a case where the phases of the clock signals for up-conversion do not match in all paths, a sample interval and a hold interval are shifted from each other and pass characteristics deteriorate.

In the present embodiment, since the signal paths from the clock signal source to the switches match, virtual short-circuiting occurs at a clock signal path end via a parasitic capacitance of each down-conversion switch between signal paths having a phase difference of 180°. Consequently, loss of the clock signal source becomes invisible, and it is possible to provide the band-pass filter that improves high frequency pass characteristics of an input signal.

Note that, although a field effect transistor is used as a transistor in the example in FIG. 11, the transistor may be a semiconductor element having the transconductance gm, and a semiconductor element such as a bipolar transistor may be used.

Note that the embodiments can be combined, and each embodiment can be modified or omitted as appropriate.

INDUSTRIAL APPLICABILITY

The band-pass filter according to the present disclosure can be used in wireless communication devices.

REFERENCE SIGNS LIST

1: Input terminal, 2: Output terminal, 3: Multi-phase splitter, 3a: Multi-phase splitter, 4: Multi-phase synthesizer, 4a: Multi-phase synthesizer, 5 to 12: Switch, 13: Capacitor, 13b: Active circuit, 13c: Current control type amplification circuit, 14: Capacitor, 14b: Active circuit, 14c: Current control type amplification circuit, 15: Capacitor, 15b: Active circuit, 15c: Current control type amplification circuit, 16: Capacitor, 16b: Active circuit, 16c: Current control type amplification circuit, 17 (b and c) to 20 (b and c) signal path, 21: Clock signal source, 31: Input terminal, 32: Output terminal, 33: Power supply terminal, 34: Bias terminal, 35: Resistance, 36: N-type transistor, 37: Variable current source, 38: P-type transistor, 39: N-type transistor, 40: Variable current source

**Claims**

1. A band-pass filter, wherein

   n represents a natural number equal to or more than one, and
   the band-pass filter comprises:

   an input terminal to receive an input of an RF signal;
   a multi-phase splitter to split the RF signal input to the input terminal into n RF signals whose phases each differ by 360 degrees/n;
   n signal paths to receive from the multi-phase splitter, sample, and hold one of the n RF signals whose phases each differ by the 360 degrees/n, and output the held signal, the n signal paths being connected to the multi-phase splitter, and each signal path including a sample hold element including two switches;
   a multi-phase synthesizer to synthesize n signals output from the n signal paths, the multi-phase synthesizer being connected to the n signal paths;
   an output terminal to output the signals to be synthesized by the multi-phase synthesizer; and
   a clock signal source to output a clock signal for driving all of switches.

2. The band-pass filter according to claim 1, wherein

   the multi-phase splitter splits the RF signal input to the input terminal into $2^n$ RF signals whose phases each differ by 360 degrees/$2^n$,
   a number of the signal paths is $2^n$, and each signal path receives from the multi-phase splitter, samples, and holds one of the $2^n$ RF signals whose phases each differ by the 360 degrees/$2^n$, and outputs the held signal,
   the multi-phase synthesizer is connected to the $2^n$ signal paths, and synthesizes the $2^n$ signals output from the $2^n$ signal paths, and
   signal paths between the clock signal source and all of the switches have equal lengths.

3. The band-pass filter according to claim 1, wherein the sample hold element includes two switches connected in series, and a capacitor connected to a connection point between the two switches and to a ground.

4. The band-pass filter according to claim 1, wherein the sample hold element includes two switches connected in series, and a first-order time-lag system active circuit disposed between the two switches and connected to the two switches.

5. The band-pass filter according to claim 1, wherein

   the sample hold element includes two switches connected in series, and a current control type amplification circuit disposed between the two switches and connected to the two switches, and
   the current control type amplification circuit is an amplification circuit that is a first-order time-lag system and has a constant pass gain even when a pass bandwidth is made variable by current control.

6. The band-pass filter according to claim 5, wherein the current control type amplification circuit includes

a second input terminal,
a power supply terminal,
a bias terminal,
a first N-type transistor including a gate terminal, a drain terminal, and a source terminal, the gate terminal of the first N-type transistor being connected to the second input terminal,
a resistance connected between the power supply terminal and the drain terminal of the first N-type transistor,
a first current source connected between the source terminal of the first N-type transistor and a ground,
a second N-type transistor including a gate terminal, a drain terminal, and a source terminal, the gate terminal of the second N-type transistor being connected to the drain terminal of the first N-type transistor,
a second current source connected between the source terminal of the second N-type transistor and the ground,
a P-type transistor including a gate terminal, a drain terminal, and a source terminal, the source terminal of the P-type transistor being connected to the power supply terminal, the gate terminal of the P-type transistor being connected to the bias terminal, and the drain terminal of the P-type transistor being connected to the drain terminal of the second N-type transistor, and
a second output terminal connected to the drain terminal of the second N-type transistor and the drain terminal of the P-type transistor.

7. The band-pass filter according to any one of claims 1 to 6, wherein the clock signal has a duty ratio of 50%.

# FIG. 1A

# FIG. 1B

# FIG. 2

# FIG. 3

# FIG. 4A

# FIG. 4B

# FIG. 5A

# FIG. 5B

FIG. 6A

RFIN

$T_{LO}/4$

4-Phase Splitting

FIG. 6B

Input Waveform After 4-Phase Splitting

Down-Conversion
Low-Pass Filtering
Up-Conversion

0°

90°

180°

270°

0°

90°

180°

270°

S1:ON    S1:OFF

4-Phase Splitting

4-Phase Synthesis

RFOUT

FIG. 6C

RFOUT

$T_{LO}/4$

# FIG. 7A

CLK Signal Source  21

S1

Multi-Phase Splitter  3

Multi-Phase Synthesizer  4

1

2

Parasitic Capacitance  S1  17b  5  13b  6  S1  Parasitic Capacitance

0°

Parasitic Capacitance  S1  18b  7  14b  8  S1  Parasitic Capacitance

$360°/2^n \times 1$

Parasitic Capacitance  S1  19b  9  15b  10  S1  Parasitic Capacitance

$360°/2^n \times 2$

Parasitic Capacitance  S1  20b  11  16b  12  S1  Parasitic Capacitance

$360°/2^n \times (2^n-1)$

# FIG. 7B

$T_{LO}$

S1

$T_{LO}/2$

# FIG. 8A

21

CLK
Signal Source

↓ S1

Parasitic
Capacitance

S1 ↓

0°

17b        5        13b

Parasitic
Capacitance

S1 ↓        6

Parasitic
Capacitance

Parasitic
Capacitance

S1 ↓

180°

3a    18b        7        14b

S1 ↓        8

4a

1 ○— Multi-Phase
Splitter

Multi-Phase
Synthesizer —○ 2

Parasitic
Capacitance

S1 ↓

90°

19b        9        15b

S1 ↓        10

Parasitic
Capacitance

Parasitic
Capacitance

S1 ↓

270°

20b        11        16b

S1 ↓        12

Parasitic
Capacitance

# FIG. 8B

$T_{LO}$

S1

$T_{LO}/2$

# FIG. 9A

# FIG. 9B

# FIG. 10A

# FIG. 10B

# FIG. 11

# FIG. 12

# FIG. 13

## INTERNATIONAL SEARCH REPORT

| International application No. |
|---|
| **PCT/JP2023/033471** |

| A. | CLASSIFICATION OF SUBJECT MATTER |
|---|---|

*H03H 19/00*(2006.01)i
FI:  H03H19/00

According to International Patent Classification (IPC) or to both national classification and IPC

| B. | FIELDS SEARCHED |
|---|---|

Minimum documentation searched (classification system followed by classification symbols)

H03H19/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2015-211392 A (ASAHI KASEI EMD CORPORATION) 24 November 2015 (2015-11-24) entire text, all drawings | 1-7 |
| A | JP 2010-268135 A (SONY CORPORATION) 25 November 2010 (2010-11-25) entire text, all drawings | 1-7 |
| A | JP 2006-319999 A (FUJITSU LIMITED) 24 November 2006 (2006-11-24) entire text, all drawings | 1-7 |
| A | JP 2008-011493 A (MATSUSHITA ELECTRIC INDUSTRIAL CO., LTD.) 17 January 2008 (2008-01-17) entire text, all drawings | 1-7 |
| A | US 2016/0380618 A1 (MEDIATEK INC.) 29 December 2016 (2016-12-29) entire text, all drawings | 1-7 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **09 November 2023** | **21 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/033471**

| Patent document cited in search report | | | Publication date (day/month/year) | Patent family member(s) | | | Publication date (day/month/year) |
|---|---|---|---|---|---|---|---|
| JP | 2015-211392 | A | 24 November 2015 | (Family: none) | | | |
| JP | 2010-268135 | A | 25 November 2010 | US entire text, all drawings CN | 2010/0289567 101888222 | A1 A | |
| JP | 2006-319999 | A | 24 November 2006 | (Family: none) | | | |
| JP | 2008-011493 | A | 17 January 2008 | US entire text, all drawings WO CN | 2009/0009155 2007/102459 101395798 | A1 A1 A | |
| US | 2016/0380618 | A1 | 29 December 2016 | WO entire text, all drawings CN | 2015/135508 105659496 | A1 A | |

Form PCT/ISA/210 (patent family annex) (January 2015)

28

## EP 4 761 110 A1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011082875 A